# EUROPEAN PATENT APPLICATION

(11) **EP 0 601 615 A1**
(43) Date of publication of application: **15.06.1994**
(21) Application number: 93202486.2
(22) Date of filing: 24.08.1993
(51) Int. Cl.: H01L 21/68

(54) **Method of manufacturing a semiconductor device whereby a semiconductor body is temporarily fastened to a further body for a processing operation**

(30) Priority: 08.12.1992 EP 92203814
(71) Applicant: Philips Electronics N.V., 5621 BA Eindhoven (NL)
(72) Inventor: Schelwald, Peter Johann Eduard, NL-5656 AA Eindhoven (NL)
(74) Representative: Veerman, Jan Willem

(57) **Abstract**

A method of carrying out an operation on a semiconductor body (1) during which a further body (2) is fastened to the semiconductor body (1) by means of an adhesive (3), the operation is carried out, and the semiconductor body (1) is detached from the further body (2) and divested of the adhesive (3). According to the invention, a carbohydrate or a mixture of carbohydrates is used as the adhesive. It is achieved by this that the semiconductor body can be divested of the adhesive by means of polar or slightly apolar solvents which are much less harmful to humans and the environment than apolar solvents which are used for known adhesives.

## Description

The invention relates to a method of carrying out an operation of a semiconductor body for which a further body is fastened to the semiconductor body by means of an adhesive, the operation is carried out, and the semiconductor body is detached from the further body and divested of the adhesive.

During the production of semiconductor devices, semiconductor bodies are often subjected to mechanical operations such as, for example, polishing, physical operations such as the application of a mask or implantation, and chemical operations such as etching. Further bodies, for example, serving as a carrier or a mask, are temporarily attached on or to the semiconductor body by means of an adhesive during many of these operations. The adhesive may be provided between the bodies, for example in the form of a hot viscous liquid, after which a solid joint between the bodies is formed through cooling-down of the adhesive. After the operation(s), the semiconductor body is detached from the further body and the semiconductor body or both bodies are divested of the adhesive.

S.M. Sze, "VLSI Technology", McGraw-Hill, second edition, 1988, p. 43, discloses a method of the kind mentioned in the opening paragraph in which a semiconductor slice is fixed on a metal plate by means of a wax. The operation involves polishing of the slice. The slice is detached after the operation and the wax is removed with solvents.

The known method has the disadvantage that harmful substances are used. Waxes often comprise esters of higher monobasic carbonic acids and higher monobasic alcohols. Such substances must be removed by means of apolar solvents such as - possibly chlorinated - hydrocarbons such as trichloroethane, or aromatic hydrocarbons such as toluene. Such solvents are harmful to humans and the environment, so that a replacement of such solvents by less harmful ones in production processes is desirable.

The invention has for its object *inter alia* to provide a method whereby solvents which are less harmful to humans and the environment than the said apolar solvents can be used for removing the adhesive.

According to the invention, the method is for this purpose characterized in that a carbohydrate or a mixture of carbohydrates is used as the adhesive. Carbohydrates are substances comprising carbon, hydrogen and oxygen atoms. The adhesive may comprise besides carbohydrates also solvents such as water. It is found that carbohydrates have a sufficient adhesive power for being used as an adhesive, while they are soluble in polar or slightly apolar solvents such as water, alcohol, or ketones. Such solvents are much less harmful than apolar solvents or even, as in the case of water, completely safe for humans and the environment. In addition, carbohydrates themselves are also safe.
Semiconductor bodies are manufactured in a very pure form with well-controlled quantities of dopant atoms. The adhesive accordingly should be free from impurities which remain on or in the semiconductor body after removal of the adhesive because these impurities can affect the operation of devices made by means of the semiconductor bodies. It is found that carbohydrates are commercially available which are sufficiently free from impurities for being used as an adhesive for semiconductor bodies.

Furthermore, carbohydrates are also sufficiently inert for not reacting with semiconductor materials or with a metallization, for example of aluminium, provided on the semiconductor body.

Although carbohydrates such as starch, pectine and sugars can be used as adhesive in the method, preferably a sugar, preferably an oligosaccharide or a mixture of mainly oligosaccharides is used. Sugars have a good adhesive power, are fairly well soluble and can be made viscous by heating, a solid substance being created after cooling-down. Oligosaccharides are sugar polymers with up to eight saccharide units in a sugar molecule. These sugars are very well soluble in, for example, water. Moreover, the softening properties of these sugars are such that they exhibit a treacly behaviour at a comparatively low temperature. An example of such a sugar is glucose syrup. Preferably, a 1-4 diglucosyl is used as the oligosaccharide. This sugar has a high thermal stability which renders it possible to store the adhesive at approximately 200°C for more than a week without degradation effects. This renders this sugar highly suitable for being kept in store, for example in a dispensing unit, during a production process of semiconductor devices.

An additional advantage is obtained when the adhesive is provided with a colouring agent, preferably one which is harmless to humans and the environment, and a transparent body is taken as the further body. It is possible then to look through the transparent body at the adhesive during fastening for checking the homogeneity of the layer thickness of the adhesive. It is also perfectly possible to observe whether the adhesive is present everywhere, so that there are no locations without adhesive.

In a first embodiment, a support body having a very plane and smooth main surface is fastened to the semiconductor body so as to serve as the further body, after which the semiconductor body is polished. For example, a semiconductor slice is used as the semiconductor body. The main surface of the support body on which the semiconductor slice is fastened is used as a reference plane during polishing. It is important in this case that the layer thickness of the adhesive is constant. Preferably, accordingly, a transparent support body and an adhesive provided with a harmless colouring agent are used for checking the layer thickness.

In a further embodiment, a masking body is fastened to the semiconductor body so as to serve as the further body, after which material is removed from the semiconductor body where it is not screened by the masking body. Thus masking bodies, for example metal masking discs, may be fastened on a surface of a semiconductor slice. These masking discs can screen portions of the surface of the semiconductor body during the removal of material from the body, for example through etching or sandblasting.

Preferably, the semiconductor body is divested of the adhesive through dissolving of the adhesive in a polar or slightly apolar solvent. Such solvents, such as water, alcohols and ketones, are comparatively harmless to humans and the environment, while carbohydrates satisfactorily dissolve in such solvents. An additional advantage is obtained when the semiconductor body is divested of the adhesive through dissolving of the adhesive in water. Carbohydrates dissolve well in water, while water is perfectly harmless to humans and the environment.

The invention also relates to a device provided with a semiconductor body and one or several further bodies which are joined together by means of a removable adhesive. According to the invention, the adhesive comprises a carbohydrate or a mixture of carbohydrates. Such a device has the advantage that the bodies can be separated from one another in an environmentally friendly manner through dissolving of the adhesive in polar or slightly apolar solvents such as water.

The invention is explained in more detail below by way of example with reference to drawings in which:
Fig. 1 shows a semiconductor slice to which a support body is fastened by means of an adhesive;
Fig. 2 shows a support body to which two semiconductor slices separated by an oxide are fastened by means of an adhesive; and
Fig. 3 shows a semiconductor slice to which a support body and masking bodies are fastened by means of an adhesive.

The Figures are purely diagrammatic and not drawn to scale. Corresponding parts are generally given the same reference numerals in the Figures.

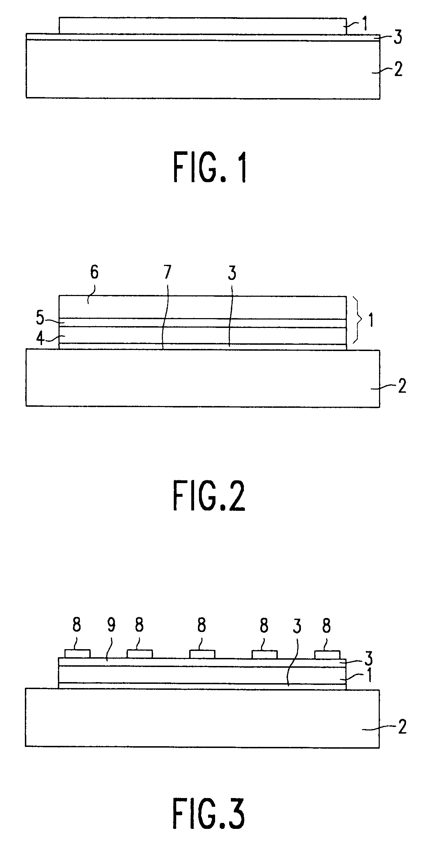

The invention relates to a method of carrying out an operation on a semiconductor body 1, for which a further body 2 is fastened to the semiconductor body 1 with an adhesive 3, the operation is carried out, and the semiconductor body 1 is detached from the further body 2 and is divested of the adhesive 3 (see Fig. 1). In practice, semiconductor bodies 1 such as semiconductor slices are often subjected to mechanical, physical and chemical processes during the manufacture of semiconductor devices. The semiconductor body 1 is often fastened to a carrier 2 during mechanical operations, after which operations such as, for example, grinding, polishing, or groove scoring are carried out on the semiconductor body 1. During physical operations, such as, for example, photoresist irradiation or implantation, further bodies 2 are provided, for example, in the form of masking bodies. In chemical treatments such as etching, portions of the semiconductor body 1 may be screened by masking bodies. The further bodies 2 are temporarily fastened on or to the semiconductor body 1 with an adhesive 3 during many of these operations. The adhesive 3 may be provided in various ways. Thus the adhesive 3 may be provided on a surface of the semiconductor body 1 or of the further body 2. The bodies are then pressed together and a secure joint between the semiconductor body 1 and the further body 2 is formed by the disappearance of solvent from the adhesive 3. It is also possible to provide the adhesive 3 between the bodies 1, 2 in the form of a hot viscous liquid, after which a solid joint between the bodies 1, 2 is formed by cooling-down of the adhesive 3. After the treatment, the semiconductor body 1 is detached from the further body 2 and the bodies 1, 2 are divested of the adhesive. This detaching may be achieved by dissolving the adhesive 3, whereby the bodies 1, 2 are at the same time separated from one another, or by heating the bodies 1, 2, which softens the adhesive, separating the bodies 1, 2, and removing the adhesive 3 through dissolving.

In a known method, the adhesive 3 consists of wax. After the operation, the semiconductor body 1 is detached and the wax is removed with solvents. This has the disadvantage that harmful substances are used. Waxes often comprise esters of higher monobasic carbonic acids and higher monobasic alcohols. In addition, waxes practically always comprise some unbonded carbonic acids and alcohols, and also often hydrocarbons. Such substances must be removed by means of apolar solvents such as - possibly chlorinated - hydrocarbons such as trichloroethane or trichloromethane, or aromatic hydrocarbons such as toluene or benzene. Such solvents are harmful to humans and the environment, so that replacement of such solvents by less harmful ones in production processes is desirable or even required.

According to the invention, a carbohydrate or a mixture of carbohydrates is used as the adhesive 3. Carbohydrates are substances containing carbon, hydrogen and oxygen atoms. These substances are found to have a sufficient adhesive power for use as the adhesive 3, while polar or slightly apolar solvents can be used for their removal, which solvents are much less harmful than the said apolar solvents. In addition, carbohydrates themselves are also harmless. The adhesive 3 may comprise besides carbohydrates also solvents such as, for example, water. Semiconductor bodies 1 are used in a very pure form with well-controlled quantities of dopant atoms. The adhesive 3 should accordingly be free from impurities which remain on or in the semiconductor body 1 after removal of the adhesive 3 because these impurities may affect the operation of devices made by means of the semiconductor bodies 1. It is found that carbohydrates are commercially available which are sufficiently free from impurities for being used as the adhesive 3 for semiconductor bodies 1.

Furthermore, carbohydrates are also sufficiently inert for not reacting with semiconductor material or with a metallization, for example of aluminium, provided on the semiconductor body.

Although carbohydrates such as starch, pectine and sugars can be used as the adhesive 3 in the method, preferably a sugar is used as the carbohydrate, preferably an oligosaccharide or a mixture of mainly oligosaccharides. Sugars have a good adhesive power, are fairly well soluble, and can be made viscous through heating, a solid substance being created by cooling-down. Oligosaccharides are sugar polymers with up to eight saccharide units in a sugar molecule. These sugars are very well soluble, for example in water. Moreover, the softening properties of these sugars are such that they exhibit a treacly behaviour at a comparatively low temperature. An example of such a sugar is glucose syrup. Glucose syrup is an aqueous solution of saccharose oligomers. By way of example, a glucose syrup comprises approximately 20% monomer, approximately 15% dimer, approximately 12% trimer, approximately 10% tetramer, approximately 8% pentamer, approximately 6% hexamer, approximately 5% heptamer, and approximately 24% higher oligomers. To make a good adhesive 3, approximately 15% cold water is added to the sugar. This mixture is mixed by rolling for 2 days. The viscosity is then 1500 mPas at 23°C. Preferably, a 1-4 diglucosyl is used as the oligosaccharide, also known under the commercial names of palatinite or ISOMALT. This sugar is used in the food industry for sweetening pastry. To obtain a good adhesive 3, for example, approximately 600 g 1-4 diglucosyl sugar and 200 ml demineralized water are evaporated to a boiling temperature of 170°C. The adhesive 3 is then ready after cooling-down. The 1-4 diglucosyl sugar has a high thermal stability which renders it possible to keep the adhesive 3 for more than a week at temperatures of up to approximately 200°C without degradation effects. This renders this sugar highly suitable for storage during a manufacturing process, for example, in a heated dispensing apparatus.

An additional advantage is obtained when the adhesive 3 is provided with a, preferably harmless, colouring agent, and when a transparent body is taken as the further body 2. It is possible then to look through the transparent body at the adhesive 3 during fastening for checking the homogeneity of the layer thickness of the adhesive 3. It is also perfectly possible to observe whether the adhesive 3 is present everywhere, so that there are no locations without adhesive 3. Substances used in the food industry for colouring foods may be used as the colouring agents. Such substances have been extensively tested for their harmlessness to humans and the environment. For example, indigo carmine may be used. This substance has a very strong blue colour. Thus, for example, 60 g indigo carmine may be added to 1.5 1 adhesive 3, for example, comprising 1-4 diglucosyl sugar. To obtain a good distribution of the colouring agent in the adhesive, the adhesive 3 and the colouring agent are mixed in a ball mill. Before use, the adhesive comprising the colouring agent may be further prepared, for example, by mixing one part adhesive 3 comprising the colouring agent with nine parts adhesive 3 without colouring agent.

Preferably, a support body 2 with a very plane and smooth main surface is fastened as the further body 2 to the semiconductor body 1, after which the semiconductor body 1 is polished (see Fig. 2). Two semiconductor slices 4, 6 interconnected by wafer bonding and separated by an oxide layer 5 are used in this example as the semiconductor body 1. A SOI ("Silicon On Insulator") structure is then made by the method in that the semiconductor slice 6 is rendered thin through grinding and polishing. The main surface 7 of the support body 2 on which the semiconductor slice 4 is fastened is used as a reference surface during polishing. The semiconductor slice 4 is fastened thereon with the adhesive 3. It is important here for the layer thickness of the adhesive 3 to be constant. A transparent support body 2 and an adhesive 3 provided with indigo carmine, prepared as described above, are accordingly used. Irregularities in the layer thickness of the adhesive are then visible as colour variations of the adhesive. Thus, for example, an optically smooth quartz support body 2 with a planeness of at least 0.5 µm is used. 1-4 diglucosyl sugar provided with indigo carmine is used as the adhesive 3. For this purpose, the adhesive 3 is heated to a temperature of 160°C while the semiconductor slices are heated to approximately 245°C. The adhesive 3 is then provided on the semiconductor slice 4 by a dispensing apparatus. The support body 2 is also heated to 245°C. The hot support body 2 is then laid on the semiconductor body 4 and pressed home until a layer thickness of approximately 10-15 µm is obtained. The semiconductor slices 4, 6, the support body 2 and the adhesive 3 are then cooled down to room temperature. The semiconductor slices 6 are subsequently subjected to a usual grinding treatment whereby the thickness of the semiconductor slice 6 is reduced to approximately 50 µm. A surface is created thereby with a high geometric precision. In a next step, the thickness of the slice 6 is reduced to approximately 10 µm in a usual polishing process. After polishing, the support body 2 with the slices 4, 6 and the adhesive 3 is heated to approximately 245°C, after which the support body 2 is taken from the slices 4, 6. The adhesive 3 is then removed from the slices 4, 6 with water of approximately 90°C.

Preferably, a masking body 8 is fastened to the semiconductor body 1 so as to serve as the further body 2, after which material is removed from the semiconductor body 1 where it is not screened by the masking body 8 (see Fig. 3). Thus masking bodies 8, for example metal masking discs 8, may be fastened on a surface of a semiconductor slice 1. These masking discs 8 can protect a portion of the surface of the semiconductor slice 1 during the removal of material from the slice 1. The slice 1 is for this purpose fastened to a glass plate 2 in a manner analogous to that described for grinding and polishing of a SOI slice above. The glass plate 2 renders it possible to check whether the adhesive 3 is present in a sufficient quantity between the glass plate 2 and the semiconductor slice 1 everywhere. Approximately 2 ml glucose syrup prepared as described above is then provided on the free surface 9 of the semiconductor slice by a dispenser. The adhesive 3 is inspissated to a certain extent through spinning and drying (1 hour at approximately 100°C). The slice 1 is then immersed in water and dabbed with paper. The slice is subsequently heated to a temperature of approximately 140°C, after which steel masking discs 8 are provided through a jig. The masking discs 8 are then pressed home with a roller. Then the material of the slice 1 not covered by the masking discs 8 is removed in a sand-blasting process. The material of the slice 1 is removed down to the glass plate 2, so that separate semiconductor bodies are created. Since it was previously checked whether adhesive 3 was present everywhere, the separate semiconductor bodies are all well connected to the glass plate 2. The glass plate 2, the separate semiconductor bodies and the masking discs 8 are separated from one another by dissolving of the adhesive in water. The subdivision of the semiconductor slice 1 into separate semiconductor bodies renders the adhesive 3 comparatively well accessible to the solvent. It is not necessary, accordingly, first to separate the semiconductor bodies from the glass plate 2 and the masking discs 8 by heating.

Preferably, the semiconductor body 1 is divested of the adhesive 3 through dissolving of the adhesive 3 in a polar or slightly apolar solvent. Such solvents, such as water, alcohols and ketones, are comparatively harmless to humans and the environment, while carbohydrates dissolve fairly well in such solvents. Examples of alcohols which can be used are methanol, ethanol and isopropanol. An example of a ketone is acetone. An additional advantage is obtained when the semiconductor body 1 is divested of the adhesive 3 through dissolving in water. Carbohydrates dissolve well in water, while water is perfectly harmless to humans and the environment.

The invention is not limited to the embodiments described above, but is applicable to analogous cases in which a temporary adhesive is used for fastening a semiconductor body to a further body for undergoing an operation. Although mechanical operations were especially carried out on the semiconductor body in the examples, it will be obvious that, also if physical or chemical operations are carried out, this will not detract from the invention.

## Claims

1. A method of carrying out an operation of a semiconductor body for which a further body is fastened to the semiconductor body by means of an adhesive, the operation is carried out, and the semiconductor body is detached from the further body and divested of the adhesive, characterized in that a carbohydrate or a mixture of carbohydrates is used as the adhesive.

2. A method as claimed in Claim 1, characterized in that a sugar, preferably an oligosaccharide or a mixture of mainly oligosaccharides, is used as the carbohydrate.

3. A method as claimed in Claim 2, characterized in that a 1-4 diglucosyl is used as the sugar.

4. A method as claimed in any one of the preceding Claims, characterized in that the adhesive is provided with a colouring agent, preferably one which is harmless to humans and the environment, and a transparent body is taken as the further body.

5. A method as claimed in any one of the preceding Claims, characterized in that a support body having a very plane and smooth main surface is fastened to the semiconductor body so as to serve as the further body, after which the semiconductor body is polished.

6. A method as claimed in any one of the Claims 1 to 4, characterized in that a masking body is fastened to the semiconductor body so as to serve as the further body, after which material is removed from the semiconductor body where it is not screened by the masking body.

7. A method as claimed in any one of the preceding Claims, characterized in that the semiconductor body is divested of the adhesive through dissolving of the adhesive in a polar or slightly apolar solvent.

8. A method as claimed in any one of the preceding Claims, characterized in that the semiconductor body is divested of the adhesive through dissolving of the adhesive in water.

9. A device provided with a semiconductor body and one or several further bodies which are joined together by means of a removable adhesive, characterized in that the adhesive comprises a carbohydrate or a mixture of carbohydrates.
